# EUROPÄISCHE PATENTANMELDUNG

(11) **EP 3 974 246 A1**
(43) Veröffentlichungstag der Anmeldung: **30.03.2022**
(21) Anmeldenummer: 21198014.9
(22) Anmeldetag: 21.09.2021
(51) Int. Cl.: B60L 58/16, H02J 7/00

(54) **VERFAHREN UND VORRICHTUNG ZUR ROBUSTEN VORHERSAGE DES ALTERUNGSVERHALTENS EINES ENERGIESPEICHERS IN EINER BATTERIEBETRIEBENEN MASCHINE**

(30) Priorität: 29.09.2020 DE 102020212297
(71) Anmelder: Robert Bosch GmbH, 70442 Stuttgart (DE)
(72) Erfinder: Woll, Christoph, 70839 Gerlingen (DE); Simonis, Christian, 71229 Leonberg (DE)

(57) **Zusammenfassung**

Die Erfindung betrifft ein computer-implementiertes Verfahren zum Bestimmen eines prädizierten Alterungszustands eines elektrischen Energiespeichers (41) in einer Maschine (4), insbesondere eines elektrisch antreibbaren Kraftfahrzeugs, mit folgenden Schritten:
- Bereitstellen (S1) eines datenbasierten oder hybriden Alterungszustandsmodells, wobei das datenbasierte Alterungszustandsmodell trainiert ist, um abhängig von Betriebsgrößen (F) eines Energiespeichers (41) und/oder aus Betriebsgrößen (F) abgeleiteten Betriebsmerkmalen (M) einen Alterungszustand anzugeben und eine Modellunsicherheit des angegebenen Alterungszustands anzugeben;
- Ermitteln (S4) eines Alterungszustandsverlaufs und der zugeordneten Modellunsicherheit eines bestimmten Energiespeichers (41) abhängig von dessen Betriebsgrößen (F) mithilfe des Alterungszustandsmodells;
- Generieren (S6) eines oder mehrerer zufälliger konstruierter Alterungszustandsverlaufskandidaten, die konstruierten Alterungszustandsverläufen innerhalb eines Verlaufs von Konfidenzintervallen entsprechen, wobei der Verlauf der Konfidenzintervalle durch die Modellunsicherheiten der Alterungszustände des ermittelten Alterungszustandsverlaufs bestimmt ist;
- aus einer Vielzahl von bereitgestellten Alterungszustandsverläufen von realen Energiespeichern (41) von weiteren Maschinen (4), Auswählen (S8) einer Anzahl von realen Alterungszustandsverläufen, die zu dem einen oder den mehreren Alterungszustandsverlaufskandidaten am nächstliegenden sind;
- Ermitteln (S9) einer Wahrscheinlichkeitsdichte über die ausgewählten realen Alterungszustandsverläufe, insbesondere durch Anfitten, um einen Verlauf des Mittelwerts des Alterungszustands als prädizierter Alterungszustandsverlauf zu bestimmen;
- Signalisieren (S11) des prädizierten Alterungszustandsverlaufs.

## Beschreibung

### Technisches Gebiet

Die Erfindung betrifft batteriebetriebene Maschinen, wie elektrisch antreibbare Kraftfahrzeuge, insbesondere Elektrofahrzeuge oder Hybridfahrzeuge, und weiterhin Maßnahmen zur Bestimmung eines Alterungszustands (SOH: State of Health) eines elektrischen Energiespeichers für eine batteriebetriebene Maschine.

### Technischer Hintergrund

Die Energieversorgung von batteriebetriebenen Maschinen und Geräten, wie insbesondere elektrisch antreibbaren Kraftfahrzeugen, erfolgt mithilfe eines elektrischen Energiespeichers, wie z.B. einer Fahrzeugbatterie. Dieser liefert elektrische Energie zum Betrieb von Maschinensystemen. Der Alterungszustand des elektrischen Energiespeichers verschlechtert sich im Laufe seiner Lebensdauer zusehends, was sich in einer abnehmenden maximalen Speicherkapazität auswirkt. Ein Maß der Alterung des elektrischen Energiespeichers hängt von einer individuellen Belastung des Energiespeichers, d. h. vom Nutzungsverhalten eines Benutzers, und vom Typ des Energiespeichers ab.

Zwar kann mithilfe eines physikalischen Alterungsmodells der momentane Alterungszustand basierend auf historischen Betriebsgrößenverläufen bestimmt werden, jedoch ist dieses Modell häufig sehr ungenau. Diese Ungenauigkeit des herkömmlichen Alterungsmodells erschwert eine Prädiktion des Alterungszustandsverlaufs. Jedoch ist die Prädiktion des Verlaufs des Alterungszustands des Energiespeichers eine wichtige technische Größe, da mit ihr eine wirtschaftliche Bewertung eines Restwerts des Energiespeichers möglich ist.

### Offenbarung der Erfindung

Erfindungsgemäß sind ein Verfahren zum Bestimmen eines prädizierten Alterungszustands eines elektrischen Energiespeichers in einer batteriebetriebenen Maschine, insbesondere eines elektrisch antreibbaren Kraftfahrzeugs, gemäß Anspruch 1 sowie eine Vorrichtung und eine batteriebetriebene Maschine gemäß den nebengeordneten Ansprüchen vorgesehen.

Weitere Ausgestaltungen sind in den abhängigen Ansprüchen angegeben.

Gemäß einem ersten Aspekt ist ein Verfahren zum Bestimmen eines prädizierten Alterungszustands eines elektrischen Energiespeichers in einer batteriebetriebenen Maschine, insbesondere in einem elektrisch antreibbaren Kraftfahrzeugs, vorgesehen, mit folgenden Schritten:
- Bereitstellen eines datenbasierten Alterungszustandsmodells, wobei das datenbasierte Alterungszustandsmodell trainiert ist, um abhängig von Betriebsgrößen eines Energiespeichers und/oder aus Betriebsgrößen abgeleiteten Betriebsmerkmalen einen Alterungszustand anzugeben und eine Modellunsicherheit des angegebenen Alterungszustands anzugeben;
- Ermitteln eines Alterungszustandsverlaufs und der zugeordneten Modellunsicherheit eines bestimmten Energiespeichers abhängig von dessen Betriebsgrößen mithilfe des Alterungszustandsmodells;
- Generieren eines oder mehrerer zufälliger konstruierter Alterungszustandsverlaufskandidaten, die konstruierten Alterungszustandsverläufen innerhalb eines Verlaufs von Konfidenzintervallen entsprechen, wobei der Verlauf der Konfidenzintervalle durch die Modellunsicherheiten der Alterungszustände des ermittelten Alterungszustandsverlaufs bestimmt ist;
- aus einer Vielzahl von bereitgestellten Alterungszustandsverläufen von realen Energiespeichern von weiteren Maschinen, Auswählen einer Anzahl von realen Alterungszustandsverläufen, die zu dem einen oder den mehreren Alterungszustandsverlaufskandidaten am nächstliegenden sind;
- Ermitteln einer Wahrscheinlichkeitsdichte über die ausgewählten realen Alterungszustandsverläufe, insbesondere durch Anfitten, um ein Konfidenzintervall zu erhalten, mit der ein prädizierter Alterungszustandsverlauf bestimmt wird;
- Signalisieren des prädizierten Alterungszustandsverlaufs und/oder der einhergehenden berechneten Lebensdauerabschätzung

Der Alterungszustand eines wiederaufladbaren elektrischen Energiespeichers, insbesondere einer Fahrzeugbatterie, wird üblicherweise nicht direkt gemessen. Dies würde eine Reihe von Sensoren in dem Energiespeicher und/oder Eingriffe in den Energiespeicher erfordern, die die Herstellung eines solchen Energiespeichers aufwendig machen und den Raumbedarf vergrößern würde. Zudem sind automotive-taugliche Verfahren zur Alterungszustandsbestimmung in der Maschine noch nicht auf dem Markt verfügbar.

Daher wird der aktuelle Alterungszustand in der Regel mithilfe eines physikalischen Alterungsmodells ermittelt. Dieses physikalische Alterungszustandsmodell ist in bestimmten Situationen ungenau und weist Modellabweichungen von mehr als 5% auf. Aufgrund der Ungenauigkeit des physikalischen Alterungsmodells kann dieses zudem lediglich den momentanen Alterungszustand des Energiespeichers angeben. Eine Prädiktion des Alterungszustands mithilfe eines rein physikalischen Alterungsmodells, die insbesondere von der Betriebsweise des Energiespeichers, wie z. B. von der Höhe und Menge des Ladungszuflusses und Ladungsabflusses bei einer Batterie, und damit von einem Nutzungsverhalten und von Maschinenparametern abhängt, ist derzeit nicht vorgesehen.

Der Alterungszustand (SOH: State of Health) ist die Schlüsselgröße zur Angabe einer verbleibenden Leistungsfähigkeit eines Energiespeichers, insbesondere einer Batteriekapazität oder einer verbleibenden Batterieladung. Der Alterungszustand stellt ein Maß für die Alterung des Energiespeichers dar und kann bei einer Batterie als Kapazitätserhaltungsrate (Capacity Retention Rate, SOH-C) oder als Anstieg des Innenwiderstands (SOH-R) angegeben werden. Die Kapazitätserhaltungsrate SOH-C ist als Verhältnis der gemessenen momentanen Kapazität zu einer Anfangskapazität der vollständig aufgeladenen Batterie angegeben. Die relative Änderung des Innenwiderstands SOH-R steigt mit zunehmender Alterung der Batterie an.

Grundsätzlich ist es möglich, durch eine Prädiktion des Verlaufs des Alterungszustands der Batterie, insbesondere mit Hilfe eines geeigneten auf Flottendaten basierenden datenbasierten Alterungszustandsmodells, zu bestimmen, wann ein Zielwert des Alterungszustands bzw. eine Restlebensdauer von null erreicht wird. Dies kann einem Benutzer signalisiert werden, um diesen zu veranlassen, den Energiespeicher der Maschine bzw. die Batterie auszutauschen. Auch ist die Angabe über die Restlebensdauer hilfreich, um festzustellen oder frühzeitig abzuschätzen, ob eine garantierte Gesamtlebensdauer der Batterie entsprechend den Herstellerangaben eingehalten wird.

Das obige Verfahren nutzt eine benutzer- und maschinenindividuelle Prädiktion eines Alterungszustands der Batterie einer bestimmten Maschine basierend auf einem datenbasierten Alterungszustandsmodell. Das datenbasierte Alterungszustandsmodell kann auch hybride Modelle (physikalisches, z.B. elektrochemisches Modell, kombiniert mit Supervised Learning Algorithmen) umfassen. Das datenbasierte Alterungszustandsmodell ist maschinenextern in einer Zentraleinheit implementiert, die mit einer Vielzahl von Maschinen in Kommunikationsverbindung steht. Das datenbasierte Alterungszustandsmodell kann so mithilfe von ausgewerteten Flottendaten erstellt und zusehends verbessert werden und gleichzeitig für alle Maschinen (bei Fahrzeugen werden die einzelnen Fahrzeuge der Fahrzeugflotte als Maschinen bezeichnet) modellierte Alterungszustände bereitstellen, die auf Grundlage einer großen Datenbasis ermittelt werden.

Das datenbasierte Alterungszustandsmodell kann mit Hilfe eines probabilistischen Regressionsmodells, insbesondere eines Gauß-Prozess-Modells, oder eines Bayesschen neuronalen Netzwerks gebildet werden bzw. dieses umfassen. Solche Modelle haben die Eigenschaft, neben einem Vorhersagewert/Modellwert auch eine Modellunsicherheit angeben/bereitstellen zu können. Die Modellunsicherheit sagt beispielsweise aus, welche Zuverlässigkeit / Konfidenz der durch das Modell berechnete Zustandswert hat. Ist die Modellunsicherheit hoch, so ist die Verwendung des berechneten Wertes des Alterungszustandsmodells für den betreffenden Auswertungspunkt zunächst tendenziell unzuverlässig.

Um trotzdem eine möglichst gute Prädiktion eines künftigen Alterungszustands zu ermöglichen, kann das in der Zentraleinheit (Cloud) vorliegende datenbasierte Alterungszustandsmodell statistisch verwendet werden, um einen wahrscheinlichsten prädizierten Alterungszustandsverlauf für einen bestimmten Energiespeicher basierend auf maschinenindividuellen Betriebsmerkmalen des Energiespeichers zu ermöglichen. Damit kann sichergestellt werden, dass bei der Prädiktion des Alterungszustandsverlaufs nicht nur der Modellwert des Alterungszustandsmodells, sondern auch die zugehörige Modellunsicherheit in Kombination mit Domänenwissen zur Verbesserung der Vorhersagegenauigkeit berücksichtigt und ausgewertet wird.

Die Betriebszustände des Energiespeichers werden durch zeitliche Verläufe von Betriebsgrößen aus dem Betrieb des Energiespeichers in der Maschine bestimmt. Für jeweils einen Auswertungszeitraum werden die zeitlichen Verläufe der Betriebsgrößen, wie z. B. die Verläufe des Batteriestroms, der Batteriespannung, der Batterietemperatur und des Ladezustands, durch Betriebsmerkmale charakterisiert. Die Betriebsmerkmale charakterisieren somit eine Nutzung der Batterie in dem Auswertungszeitraum und auch eine akkumulierte Nutzung über die bisherige Lebensdauer des Energiespeichers. Die Gesamtheit der Betriebsmerkmale für einen Energiespeicher (Betriebsmerkmalspunkt) bestimmt die Eingangsdaten des datenbasierten Alterungszustandsmodells bzw. den Auswertungspunkt, für den das datenbasierte Alterungszustandsmodell ausgewertet wird.

Die Prädiktion des künftigen Alterungszustands kann über Monte-Carlo-Simulationen als statistische Prozessmodellierung erreicht werden, die mit einer Nearest-Neighbor-Prädiktion verknüpft ist, welche auf Basis von Ähnlichkeits-Charakteristiken der Energiespeicher der weiteren Maschinen operiert. Dadurch können viele mögliche reale Alterungszustandsverläufe bestimmt werden und für die Prädiktion eines realistischen, wahrscheinlichsten maschinenindividuellen Alterungszustandsverlaufs verwendet werden.

Das obige Verfahren zur Ermittlung eines prädizierten Alterungszustandsverlaufs ist durch die Verbindung des Monte-Carlo-Verfahrens der zufälligen Auswahl von Alterungszustandsverlaufskandidaten innerhalb des Konfidenzintervalls des Alterungszustandsverlaufs des bestimmten Energiespeichers und die anschließende Auswahl von realen Alterungszustandsverläufen, die Alterungszustandsverlaufskandidaten am nächsten kommen, sehr robust, insbesondere bei Modellaussagen des Alterungszustandsmodells, für die das Alterungszustandsmodell nur eine sehr verrauschte, d. h. mit hoher Unsicherheit behaftete Alterungszustandsangabe bereitstellen kann. Die realen Alterungszustandsverläufe entsprechen Alterungszustandsverläufen realer Energiespeicher, vorzugsweise solcher, die ihr Lebensdauerende erreicht haben und für die ein insbesondere möglichst langfristiger, zuverlässiger Alterungszustandsverlauf, vorzugsweiseüber die gesamte Lebensdauer, vorliegt.

Weiterhin können die Alterungszustandsverlaufskandidaten plausibilisiert werden, bevor diese für die Ermittlung der Wahrscheinlichkeitsdichtefunktion verwendet werden, wobei unplausible bzw. physikalisch nicht sinnvolle Alterungszustandsverlaufskandidaten nicht für die Ermittlung der Wahrscheinlichkeitsdichtefunktion berücksichtigt werden.

Es kann vorgesehen sein, dass die Schritte des Generierens des einen oder der mehreren Alterungszustandsverlaufskandidaten und des Auswählens von realen Alterungszustandsverläufen mehrfach durchgeführt werden, wobei die ausgewählten realen Alterungszustandsverläufe jeweils einer Auswertemenge hinzugefügt werden, wobei das Ermitteln der Wahrscheinlichkeitsdichtefunktion abhängig von den ausgewählten realen Alterungszustandsverläufen der Auswertemenge durchgeführt wird.

Insbesondere kann das mehrfache Ausführen der Schritte so lange durchgeführt werden, bis ein Konvergenzkriterium erfüllt ist, wobei das Konvergenzkriterium von einer gesamten Konfidenz oder einer statistischen Signifikanz abhängt, die sich aus dem Iterations-Verlauf der Varianz oder der Standardabweichung der Wahrscheinlichkeitsdichte ergibt, wobei insbesondere das Konvergenzkriterium von einer Änderung der gesamten Konfidenz sämtlicher kombinierter Alterungszustandsverläufe in aufeinanderfolgenden Durchläufen der Schritte des Generierens und des Auswählens abhängt.

Gemäß einer Ausführungsform kann das Auswählen von realen Alterungszustandsverläufen, die zu dem einen oder den mehreren Alterungszustandsverlaufskandidaten am nächstliegenden sind, mithilfe eines Nearest Neighbour-Verfahrens, insbesondere unter Nutzung eines Least-Square-Verfahrens, in einem mehrdimensionalen Betriebsmerkmalsraum bezüglich des zeitlichen oder nutzungsabhängigen Verlaufs des jeweiligen Alterungszustandsverlaufskandidaten durchgeführt werden. Reale Alterungszustandsverläufe sind Alterungszustandsverläufe von realen Energiespeichern von weiteren Maschinen, die in einer Zentraleinheit gespeichert sind.

Dabei werden die Alterungszustandsverlaufskandidaten entsprechend ihres historischen Alterungszustandsverlaufs mit den realen Alterungszustandsverläufen verglichen, um bekannte, reale Alterungstrajektorien zu ermitteln, welche den durch Monte-Carlo-Sampling ermittelten, und anschließend ggfs. physikalisch plausibilisierten Alterungszustandsverlaufskandidaten ähnlich sind. Dieser Vergleich kann in einem mehrdimensionalen Betriebsmerkmalsraum erfolgen, z. B. Alterungszustandsverlauf über Zeit, Ah-Durchsatz, gefahrene Kilometer-Leistung, ..., etc. Hierbei werden nun durch Lösung des Optimierungsproblems, vorzugsweise mithilfe der kleinsten Fehlerquadrate, die *n* ähnlichsten bekannten, realen Alterungszustandsverläufe ausgewählt, wobei *n* > 0.

Weiterhin kann von den *n* ausgewählten bekannten, realen Alterungszustandsverlaufskandidaten sämtliche Alterungsinformationen bis zu ihrem Lebensdauerendpunkts, der eine Angabe zu einer bisherigen Lebensdauer (Zeitraum zwischen Inbetriebnahme und aktuellem Auswertungszeitraum) angibt, mit entsprechenden Zeitabschnitten für die Prädiktion ausgenutzt und zur Restlebensdauerbestimmung und Alterungsvorhersage sämtlicher Energiespeicher verwendet werden.

Weiterhin kann der prädizierte Alterungszustandsverlauf an die batteriebetriebene Maschine übermittelt werden, wobei diese abhängig von dem prädizierten Alterungszustandsverlauf betrieben wird.

Es kann vorgesehen sein, dass der prädizierte Alterungszustandsverlauf verwendet wird, um eine Restlebensdauer mit statistischer Unsicherheitsquantifizierung zu ermitteln und diese in nachfolgenden Verfahren zum Ausgeben von Fahrempfehlungen zu nutzen oder zu signalisieren.

Weiterhin kann der prädizierte Alterungszustandsverlauf verwendet werden, um einen Austausch der Fahrzeugbatterie bei Erreichen einer Restlebensdauer von null zu signalisieren, welche üblicherweise über den SOH (z.B. per Lebensdauer-Spezifikation: SOHC >= 80% für 8 Jahre) definiert ist. Wenn eine prädizierte Wahrscheinlichkeit für die Verletzung der Lebensdauer-Spezifikation eine vorgegebene Wahrscheinlichkeitsschwelle (z. B. 80%) überschreitet, wobei die Prädiktions-Wahrscheinlichkeit durch Integration über die Wahrscheinlichkeitsdichtefunktion bezüglich der Restlebensdauer berechnet wird.

Es kann vorgesehen sein, dass das Ermitteln einer Wahrscheinlichkeitsdichte durch Aufaddieren von Histogrammen von zu jedem Auswertungszeitpunkt der stochastisch prädizierten Alterungszuständen der ausgewählten realen Alterungszustandsverläufen durchgeführt wird.

Gemäß einem weiteren Aspekt ist eine Vorrichtung zum Bestimmen eines prädizierten Alterungszustands eines elektrischen Energiespeichers in einer batteriebetriebenen Maschine, insbesondere eines elektrisch antreibbaren Kraftfahrzeugs, vorgesehen, wobei die Vorrichtung ausgebildet ist, zum:
- Bereitstellen eines datenbasierten Alterungszustandsmodells, wobei das datenbasierte Alterungszustandsmodell trainiert ist, um abhängig von Betriebsgrößen eines Energiespeichers und/oder aus Betriebsgrößen abgeleiteten Betriebsmerkmalen einen Alterungszustand anzugeben und eine Modellunsicherheit des angegebenen Alterungszustands anzugeben;
- Ermitteln eines Alterungszustandsverlaufs und der zugeordneten Modellunsicherheit eines bestimmten Energiespeichers abhängig von dessen Betriebsgrößen mithilfe des Alterungszustandsmodells;
- Generieren eines oder mehrerer zufälliger konstruierter Alterungszustandsverlaufskandidaten, die konstruierten Alterungszustandsverläufen innerhalb eines Verlaufs von Konfidenzintervallen entsprechen, wobei der Verlauf der Konfidenzintervalle durch die Modellunsicherheiten der Alterungszustände des ermittelten Alterungszustandsverlaufs bestimmt ist;
- Auswählen einer Anzahl von realen Alterungszustandsverläufen, die zu dem einen oder den mehreren Alterungszustandsverlaufskandidaten am nächstliegenden sind, aus einer Vielzahl von bereitgestellten Alterungszustandsverläufen von realen Energiespeichern von weiteren Maschinen,;
- Ermitteln einer Wahrscheinlichkeitsdichte über die ausgewählten realen Alterungszustandsverläufe, insbesondere durch Anfitten, um ein Konfidenzintervall zu erhalten, mit der ein prädizierter Alterungszustandsverlauf bestimmt wird; und
- Signalisieren des prädizierten Alterungszustandsverlaufs.

### Kurzbeschreibung der Zeichnungen

Ausführungsformen werden nachfolgend anhand der beigefügten Zeichnungen näher erläutert. Es zeigen:
- Figur 1: eine schematische Darstellung eines Systems zur Bereitstellung von fahrer- und fahrzeugindividuellen Betriebsgrößen bezüglich des Betriebs einer Fahrzeugbatterie von Fahrzeugen einer Fahrzeugflotte an eine Zentraleinheit;
- Figur 2: eine schematische Darstellung eines funktionalen Aufbaus eines hybriden Alterungszustandsmodells;
- Figur 3: ein Flussdiagramm zur Veranschaulichung eines Verfahrens zur Ermittlung eines prädizierten Alterungszustandsverlaufs für eine Fahrzeugbatterie in einem Kraftfahrzeug mithilfe eines datenbasierten Alterungszustandsmodells; und
- Figur 4: eine beispielhafte Darstellung einer Ermittlung von Alterungszustandsverlaufskandidaten durch ein Monte-Carlo-Verfahren.

### Beschreibung von Ausführungsformen

Im Folgenden wird das erfindungsgemäße Verfahren anhand von Fahrzeugbatterien als elektrischer Energiespeicher in einer Vielzahl von Kraftfahrzeugen als batteriebetriebene Maschinen beschrieben. Für andere elektrische Energiespeicher, wie z. B. Brennstoffzellen kann das nachfolgend beschriebene Verfahren in vergleichbarer Weise angewendet werden. In den Kraftfahrzeugen kann in einer Steuereinheit ein datenbasiertes Alterungszustandsmodell für die jeweilige Fahrzeugbatterie implementiert sein. Das Alterungszustandsmodell kann in einer Zentraleinheit kontinuierlich basierend auf Betriebsgrößen der Fahrzeugbatterien aus der Fahrzeugflotte aktualisiert bzw. nachtrainiert werden.

Das obige Beispiel steht stellvertretend für eine Vielzahl von stationären oder mobilen batteriebetriebenen Maschinen und Geräte mit netzunabhängiger Energieversorgung, wie beispielsweise Fahrzeuge (Elektrofahrzeuge, Pedelecs usw.), Anlagen, Werkzeugmaschinen, Haushaltsgeräte, IOT-Geräte, eine Gebäudeenergieversorgungen, Fluggeräte, insbesondere Drohnen, autonome Roboter und Geräte der Unterhaltungselektronik, insbesondere Mobiltelefone, und dergleichen, die über eine entsprechende Kommunikationsverbindung (z. B. LAN, Internet) mit einer Zentraleinheit (Cloud) in Verbindung stehen.

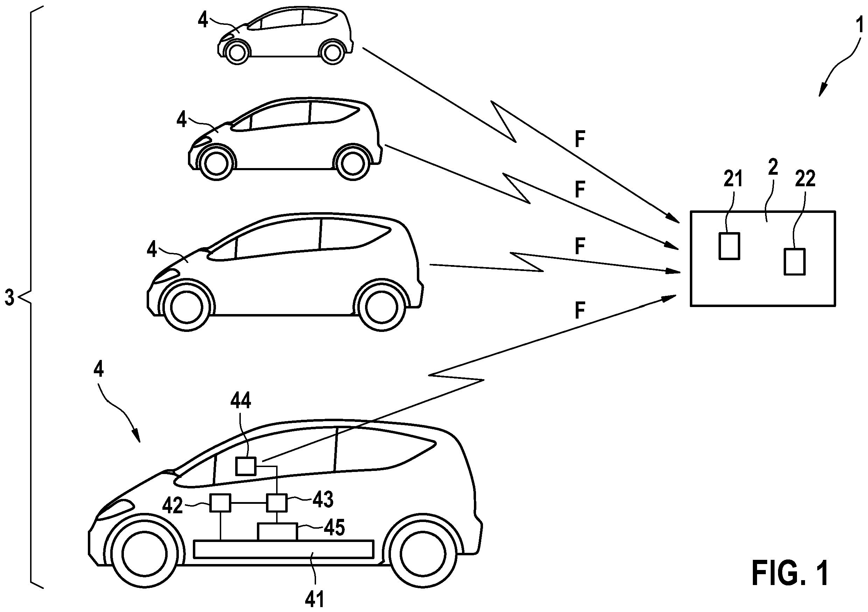

Figur 1 zeigt ein System 1 zum Sammeln von Flottendaten in einer Zentraleinheit 2 zur Erstellung und zum Betrieb sowie zur Auswertung eines Alterungszustandsmodells. Das Alterungszustandsmodell dient zur Bestimmung eines Alterungszustands eines elektrischen Energiespeichers, wie z. B. einer Fahrzeugbatterie oder einer Brennstoffzelle) in einem Kraftfahrzeug. Figur 1 zeigt eine Fahrzeugflotte 3 mit mehreren Kraftfahrzeugen 4. In der Zentraleinheit 2 soll basierend auf den Flottendaten eine Prädiktion eines Verlaufs eines Alterungszustands einer Fahrzeugbatterie eines jeweiligen Kraftfahrzeugs 4 der Fahrzeugflotte 3 vorgenommen werden.

Eines der Kraftfahrzeuge 4 ist in Figur 1 detaillierter dargestellt. Die Kraftfahrzeuge 4 weisen jeweils eine Fahrzeugbatterie 41 als wiederaufladbaren elektrischen Energiespeicher, einen elektrischen Antriebsmotor 42 und eine Steuereinheit 43 auf. Die Steuereinheit 43 ist mit einem Kommunikationsmodul 44 verbunden, das geeignet ist, Daten zwischen dem jeweiligen Kraftfahrzeug 4 und der Zentraleinheit 2 (einer sogenannten Cloud) zu übertragen. Die Steuereinheit 43 ist mit einer Sensoreinheit 45 verbunden, die einen oder mehrere Sensoren aufweist, um Betriebsgrößen kontinuierlich zu erfassen.

Die Kraftfahrzeuge 4 senden an die Zentraleinheit 2 die Betriebsgrößen F, die zumindest Größen angeben, von denen der Alterungszustand der Fahrzeugbatterie abhängt. Die Betriebsgrößen F können im Falle einer Fahrzeugbatterie einen momentanen Batteriestrom, eine momentane Batteriespannung, eine momentane Batterietemperatur und einen momentanen Ladezustand (SOC: State of Charge) angeben, sowohl auch Pack-, Modul- und / oder Zellebene. Die Betriebsgrößen F werden in einem schnellen Zeitraster von 2 Hz bis 100 Hz erfasst und können in unkomprimierter und/oder komprimierter Form regelmäßig an die Zentraleinheit 2 übertragen werden. Beispielsweise können die Zeitreihen im Abstand von 10 min bis mehreren Stunden blockweise an die Zentraleinheit 2 übertragen werden.

Die Zentraleinheit 2 weist eine Datenverarbeitungseinheit 21, in der das nachfolgend beschriebene Verfahren ausgeführt werden kann, und eine Datenbank 22 zum Speichern von Alterungszustandsverläufen von Fahrzeugbatterien einer Vielzahl von Fahrzeugen 4 der Fahrzeugflotte 3 auf.

Die Kraftfahrzeuge 4 senden an die Zentraleinheit 2 die Betriebsgrößen F, die zumindest Größen angeben, von denen der Alterungszustand der Fahrzeugbatterie abhängt. Die Betriebsgrößen F können im Falle einer Fahrzeugbatterie einen momentanen Batteriestrom, eine momentane Batteriespannung, eine momentane Batterietemperatur und einen momentanen Ladezustand (SOC: State of Charge) angeben. Die Betriebsgrößen F werden in einem schnellen Zeitraster von zwischen 2 Hz und 100 Hz erfasst, wobei deren Verläufe in unkomprimierter und/oder komprimierter Form regelmäßig an die Zentraleinheit 2 übertragen werden.

Aus den Betriebsgrößen F können in der Zentraleinheit 2 oder in anderen Ausführungsformen auch bereits in den jeweiligen Kraftfahrzeugen 4 Betriebsmerkmale generiert werden, die sich auf einen Auswertungszeitraum beziehen. Der Auswertungszeitraum kann für die Bestimmung des Alterungszustands wenige Stunden (z. B. 6 Stunden) bis mehrere Wochen (z. B. einen Monat) betragen. Ein üblicher Wert für den Auswertungszeitraum beträgt eine Woche.

Die Betriebsmerkmale können beispielsweise auf den Auswertungszeitraum bezogene Merkmale und/oder akkumulierte Merkmale und/oder über die gesamte bisherige Lebensdauer ermittelte statistische Größen umfassen. Insbesondere können die Betriebsmerkmale beispielsweise umfassen: Elektrochemische Zustände (Schichtdicken, Konzentrationen, zyklisierbares Lithium, ...), Histogrammdaten über dem Ladezustandsverlauf, der Temperatur, der Batteriespannung, des Batteriestroms, insbesondere Histogrammdaten bezüglich der Batterietemperaturverteilung über dem Ladezustand, der Ladestromverteilung über der Temperatur und/oder der Entladestromverteilung über der Temperatur, akkumulierte Gesamtladung (Ah), eine durchschnittliche Kapazitätszunahme bei einem Ladevorgang (insbesondere für Ladevorgänge, bei denen die Ladungszunahme über einem Schwellenanteil (z. B. 20%) der gesamten Batteriekapazität liegt), ein Maximum der differentiellen Kapazität (dQ/dU: Ladungsänderung dividiert durch Änderung der Batteriespannung) und weitere. Aus den Betriebsgrößen F können in der Zentraleinheit 2 oder in anderen Ausführungsformen auch bereits in den jeweiligen Kraftfahrzeugen 4 Betriebsgrößenmerkmale generiert werden, die sich auf einen Auswertungszeitraum beziehen. Der Auswertungszeitraum kann für die Bestimmung des Alterungszustands wenige Stunden (z. B. 6 Stunden) bis zu mehreren Wochen (z. B. einem Monat) betragen. Ein üblicher Wert für den Auswertungszeitraum beträgt eine Woche.

Aus den Betriebsmerkmalen lassen sich weitere Angaben entnehmen: ein zeitliches Belastungsmuster wie Lade- und Fahrzyklen, bestimmt durch Nutzungsmuster (wie bspw. Schnellladen bei hohen Stromstärken oder starke Beschleunigung bzw. Bremsvorgänge mit Rekuperation), eine Nutzungszeit der Fahrzeugbatterie, eine über die Laufzeit kumulierte Ladung und eine über die Laufzeit kumulierte Entladung, einen maximalen Ladestrom, einen maximalen Entladestrom, eine Ladehäufigkeit, einen durchschnittlichen Ladestrom, einen durchschnittlichen Entladestrom, einen Leistungsdurchsatz beim Laden und Entladen, eine (insbesondere durchschnittliche) Ladetemperatur, eine (insbesondere durchschnittliche) Spreizung des Ladezustands und dergleichen.

Der Alterungszustand (SOH: State of Health) ist die Schlüsselgröße zur Angabe einer verbleibenden Batteriekapazität oder verbleibenden Batterieladung. Der Alterungszustand stellt ein Maß für die Alterung der Fahrzeugbatterie oder eines Batterie-Moduls oder einer Batterie-Zelle dar und kann als Kapazitätserhaltungsrate (Capacity Retention Rate, SOH-C) oder als Anstieg des Innenwiderstands (SOH-R) angegeben werden. Die Kapazitätserhaltungsrate SOH-C ist als Verhältnis der gemessenen momentanen Kapazität zu einer Anfangskapazität der vollständig aufgeladenen Batterie angegeben. Die relative Änderung des Innenwiderstands SOH-R steigt mit zunehmender Alterung der Batterie an.

In der Zentraleinheit 2 ist ein Alterungszustandsmodell implementiert, das insbesondere ganz oder teilweise datenbasiert ist. Das Alterungszustandsmodell kann regelmäßig, d. h. nach Ablauf der jeweiligen Auswertungszeitdauer, verwendet werden, um basierend auf den Betriebsmerkmalen eine Ermittlung des momentanen Alterungszustands der Fahrzeugbatterie 41 vorzunehmen. Mit anderen Worten ist es möglich, basierend auf den Betriebsmerkmalen, die sich aus den Betriebsgrößenverläufen eines der Kraftfahrzeuge 4 der Flotte 3 einen Alterungszustand der betreffenden Fahrzeugbatterie 41 oder dieses Energiespeichers dazugehörigen Module bzw. Zellen, ergeben, zu ermitteln.

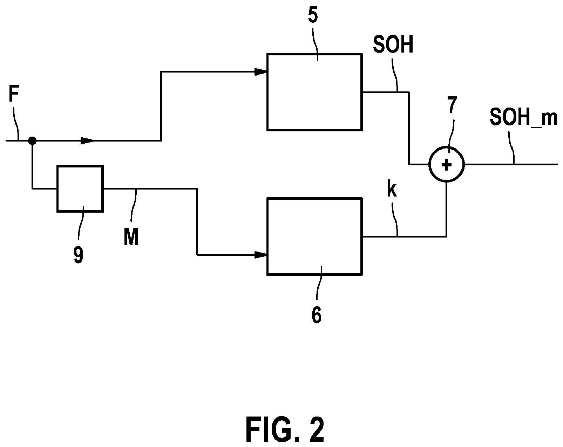

Figur 2 zeigt beispielhaft schematisch den funktionalen Aufbau einer Ausführungsform eines datenbasierten Alterungszustandsmodells 9, das in einer hybriden Weise aufgebaut ist. Das Alterungszustandsmodell 9 umfasst ein physikalisches Alterungsmodell 5 und ein Korrekturmodell 6. Diese erhalten Betriebsmerkmale M eines aktuellen Auswertungszeitraums von einem Merkmalsextraktionsblock 8 basierend auf den Zeitreihen der Betriebsgrößen F. Alternativ können die Betriebsgrößen F auch direkt in das physikalische Alterungszustandsmodell 5 eingehen, welches vorzugsweise als elektrochemisches oder empirisches Modell ausgeführt ist und entsprechende elektrochemische Zustände, wie Schichtdicken der Aktivmaterialien, Änderung des zyklisierbaren Lithiums aufgrund von Anode/Kathode-Nebenreaktionen, Aufbau der Solid Electrolyte Interface (SEI-Grenzschicht) langsamer Verbrauch von Elektrolyten, Verlust des Aktivmaterials der Anode, Verlust des Aktivmaterials der Kathode, etc....), usw. mithilfe von nichtlinearen Differentialgleichungen beschreibt.

Das physikalische Alterungsmodell 5 entspricht einem elektrochemischen Modell der Batteriezelle und der Zellchemie. Dieses Modell ermittelt abhängig von den Betriebsgrößen F interne physikalische Batteriezustände, um einen physikalisch basierten Alterungszustand in Form einer Kapazitätserhaltungsrate (SOH-C) und/oder als Innenwiderstandanstiegsrate (SOH-R) bereitzustellen. Bei einer solchen elektrochemischen Modellierung erfolgt die Berechnung von SOHc und SOH_{R} über die Ermittlung eines elektrochemischen Zustandsvektors, welcher durch Zeitintegrationsverfahren ermittelt wird.

Die durch das elektrochemische Modell bereitgestellten Modellwerte für den Alterungszustand SOH sind jedoch in bestimmten Situationen ungenau, und es ist daher vorgesehen, diese mit einer Korrekturgröße k zu korrigieren. Die Korrekturgröße k wird von dem datenbasierten Korrekturmodell 6 bereitgestellt, das mithilfe von Trainingsdatensätzen aus den Fahrzeugen 4 der Fahrzeugflotte 3 oder Labordaten trainiert wird.

Für die Bestimmung eines korrigierten Alterungszustands SOH_m werden die Ausgänge SOH, k des physikalischen Alterungsmodells 5 und des Korrekturmodells 6, welches vorzugsweise als Gauß-Prozess-Modell ausgeführt ist, miteinander beaufschlagt. Insbesondere können diese in einem Summierblock 7 addiert oder multipliziert (nicht gezeigt) werden, um den korrigierten Alterungszustand SOH_m zu einem aktuellen Auswertungszeitraum zu erhalten.

Andere Ausgestaltungen des datenbasierten Alterungszustandsmodells sind ebenfalls möglich, beispielsweise kann das datenbasierte Alterungszustandsmodell als nicht-hybrides, rein datenbasiertes Modell basierend auf einem probabilistischen oder einem auf künstlicher Intelligenz basierendem Regressionsmodell, insbesondere einem Gauß-Prozess-Modell, oder einem Bayesschen neuronalen Netz ausgebildet sein. Dieses ist trainiert, um einen Alterungszustand SOH aus einem Betriebsmerkmalspunkt, der durch aktuelle Betriebsmerkmale M eines aktuellen Auswertungszeitraums bestimmt ist, bereitzustellen, wobei die Betriebsmerkmale M in einem Merkmalsextraktionsblock 8 basierend auf den Zeitreihen der Betriebsgrößen F ermittelt werden.

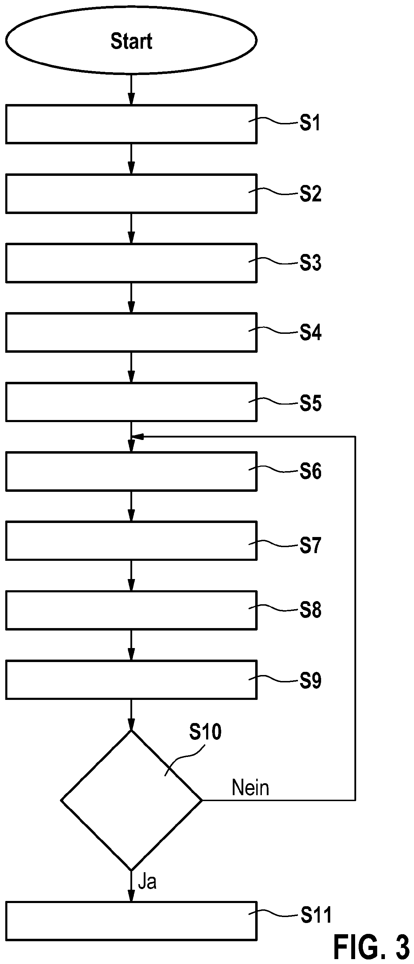

In Figur 3 ist ein Flussdiagramm dargestellt, das den Ablauf eines Verfahrens zum Ermitteln eines künftigen Verlaufs des Alterungszustands SOH für ein bestimmtes Fahrzeug 4 der Fahrzeugflotte 3 in der Zentraleinheit 2 darstellt. Dieses ermöglicht eine Abschätzung, welcher Alterungszustand SOH nach welcher weiteren Betriebsdauer erreicht wird, sowie eine Abschätzung einer Restlebensdauer. Das Verfahren kann parallel oder nacheinander für mehrere oder alle Fahrzeuge 4 der Fahrzeugflotte 3 unabhängig voneinander ausgeführt werden.

Das Verfahren wird in der Datenverarbeitungseinheit 21 in der Zentraleinheit 2 ausgeführt und kann dort als Software und/oder Hardware implementiert sein.

In Schritt S1 wird ein vortrainiertes datenbasiertes Alterungszustandsmodell, das als rein datenbasiertes Modell oder als hybrides Modell, wie oben beispielhaft beschrieben, ausgeführt ist, bereitgestellt. Das vortrainierte datenbasierte Alterungszustandsmodell kann mit einem probabilistischen Regressionsmodell, insbesondere einem Gauß-Prozess-Modell, ausgebildet sein. Das datenbasierte Alterungszustandsmodell ist trainiert, um einen Alterungszustand einer Fahrzeugbatterie für einen aktuellen Auswertungszeitraum abhängig von einem Verlauf von Betriebsgrößen und/oder einem Betriebsmerkmalspunkt bereitzustellen.

In Schritt S2 werden für einen aktuellen Auswertungszeitraum Verläufe von Betriebsgrößen F, insbesondere Verläufe des Batteriestroms, der Batteriespannung, der Batterietemperatur und des Ladezustands, von dem bestimmten Fahrzeug empfangen.

In Schritt S3 werden aus den Betriebsgrößen F zumindest ein Teil der obigen Betriebsmerkmale M gebildet.

In Schritt S4 werden durch Auswertung des datenbasierten Alterungszustandsmodells aus den Betriebsgrößenverläufen und/oder des durch die Betriebsmerkmale gebildeten Betriebsmerkmalspunkts ein aktueller Alterungszustand ermittelt. Weiterhin ermöglicht es das datenbasierte Alterungszustandsmodell, ein Maß zur Modellungenauigkeit für den modellierten Alterungszustand anzugeben.

In Verbindung mit dem historischen Verlauf des Alterungszustands der Fahrzeugbatterie 41 des bestimmten Kraftfahrzeugs 4 ist ein gespeicherter Alterungszustandsverlauf von einem Zeitpunkt der Inbetriebnahme der Fahrzeugbatterie 41 bis zum Ende des aktuellen Auswertungszeitraums in der Zentraleinheit 2 verfügbar. Zu dem historischen Verlauf des Alterungszustands der Fahrzeugbatterie 41 des bestimmten Kraftfahrzeugs sind auch die jeweiligen Modellungenauigkeiten der Modellwerte des Verlaufs des jeweiligen Alterungszustands gespeichert.

Zudem sind in der Zentraleinheit 2 zeitliche Alterungszustandsverläufe von einer Vielzahl von Fahrzeugbatterien aus weiteren Fahrzeugen der Fahrzeugflotte 3 für Zeiträume verfügbar, die sich von deren jeweiligen Inbetriebnahmezeitpunkt (Begin of Life) bis zum aktuellen Auswertungszeitraum und über diesen hinaus oder bis deren Lebensdauerende erstrecken.

In Schritt S5 werden aus dem historischen Verlauf des Alterungszustands des bestimmten Kraftfahrzeugs und den entsprechenden Modellungenauigkeiten für jeden Auswertungszeitraum ein von der Modellungenauigkeit abhängiges Konfidenzintervall von zwischen 1*σ* und 4*σ*, insbesondere von z. B. +/- 3 *σ* ermittelt, wobei *σ* typischerweise die Standardabweichung eines Konfidenzintervalls beschreibt unter der Annahme einer Normalverteilung Grundsätzlich können auch nicht-normalverteilte Konfidenzintervalle beschrieben werden.

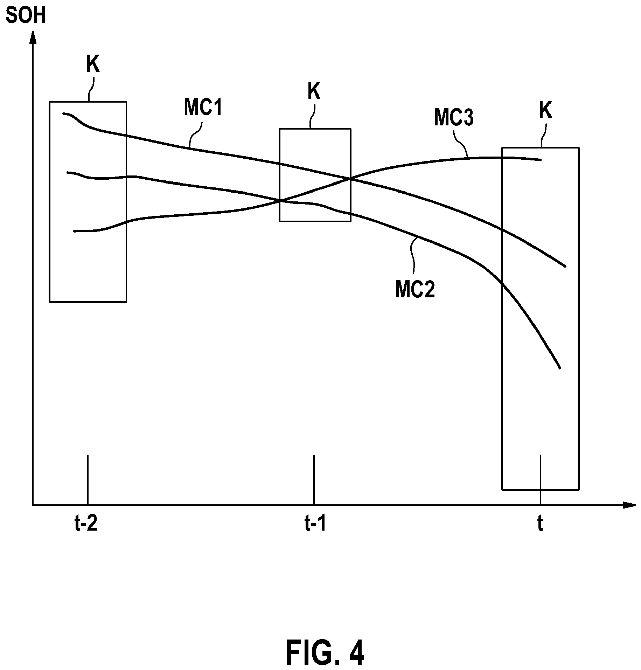

In Schritt S6 wird mithilfe eines Monte-Carlo-Verfahrens eine vorgegebene Anzahl von zufälligen Alterungszustandsverläufen aus dem durch die Konfidenzintervalle bestimmten Bereich stochastisch gesampelt, so dass man mehrere Alterungszustandsverlaufskandidaten erhält. Im Falle eines Gaußprozessmodells wird aus einer Normalverteilung gesampelt, wobei sich die Standardabweichung aus dem datenbasierten Alterungszustandsmodell (GP) ergibt. Beispielsweise können eine Anzahl von drei, vier, fünf oder beliebig vielen Alterungszustandsverlaufskandidaten ermittelt werden, die konstruierte Alterungszustandsverläufe angeben. Diese weisen jeweils eine zeitliche Länge auf, die der Länge von dem Zeitpunkt der Inbetriebnahme der bestimmten Fahrzeugbatterie zu dem Ende des aktuellen Auswertungszeitraums entspricht. Diese Vorgehensweise ist beispielsweise in Figur 4 dargestellt. Man erkennt für drei aufeinanderfolgende Auswertungszeiträume *t-2, t-1* und *t* (auf der Zeitachse , X-Achse) Konfidenzintervalle K zu dem Alterungszustandsverlauf der bestimmten Fahrzeugbatterie. Durch die Konfidenzintervalle verlaufen drei Ausschnitte aus zufälligen Alterungszustandsverläufen, bezeichnet als MC1, MC2 und MC3.

In Schritt S7 werden die so ermittelten Alterungszustandsverlaufskandidaten auf Plausibilität überprüft und nicht plausible Alterungszustandsverläufe entfernt. Die Plausibilitätsbewertung der durch die Monte-Carlo-Simulation erhaltenen konstruierten Alterungszustandsverläufe MC1, MC2 und MC3 kann sowohl modell- als auch regelbasiert erfolgen. Beispielsweise können diejenigen Alterungszustandsverlaufskandidaten entfernt werden, die einen ansteigenden Alterungszustand aufweisen, da ein Anstieg des Alterungszustandsverlaufs über ein zunehmendes Alter der Fahrzeugbatterie technisch nicht möglich und somit unplausibel ist. In dem gezeigten Beispiel wird der Alterungszustandsverlaufskandidat MC3 ausgesondert. Die Alterungszustandsverlaufskandidaten MC1 und MC2 sind dagegen plausibel und werden in einem nachfolgenden Schritt verwendet.

In Schritt S8 wird auf die Datenbank 22 der Zentraleinheit 2 zugegriffen. Hier sind reale Alterungszustandsverläufe von existierenden Fahrzeugbatterien gespeichert. Vorzugsweise werden nur diejenigen realen Alterungszustandsverläufe betrachtet, die bis zum Ende der Lebensdauer der betreffenden Fahrzeugbatterie aufgezeichnet worden sind. Wenn das Fahrzeug, für das der Alterungszustand bestimmt werden soll, deutlich jünger ist (nämlich gerade um mindestens den gewünschten Prädiktionshorizont) können auch nicht vollständige Alterungszustandsverläufe berücksichtigt werden. Für die plausibilisierten Alterungszustandsverläufe werden nun aus den realen Alterungszustandsverläufen diejenigen ausgewählt, die die größte Ähnlichkeit zu den ermittelten Alterungszustandsverlaufskandidaten aufweisen. Die Ähnlichkeit der Verläufe kann vorzugsweise auf Basis des zeitlichen Alters, der zurückgelegten Gesamt-Wegstrecke oder nutzungstypischen Merkmalen (z. B. Batterie-Alter, Ah-Durchsatz, gefahrene Kilometer-Leistung etc.) bestimmt werden. Die Beschreibung der Ähnlichkeit erfolgt somit durch das Lösen eines ein- oder mehrdimensionalen Optimierungsproblems. Dies kann beispielsweise mithilfe eines Nearest-Neighbor-Verfahrens erfolgen, bei der die Gesamtabweichung eines Alterungszustandsverlaufs von einem Alterungszustandsverlaufskandidaten bewertet wird.

Für jede mögliche Trajektorie also z. B. MC1, MC2 und MC3, wird der Nearest Neighbor-Algorithmus angewendet, indem ein Optimierungsproblem in einem mindestens 1-Dimensionalen Raum gelöst wird. Die Bestimmung der nächsten Nachbarn (Nearest Neighbor) erfolgt vorzugweise mit Minimierung der Fehlerquadrate, z. B. im Merkmalsraum: Batterie-Alter, Ah-Durchsatz, gefahrene Kilometerleistung, usw. Es wird dazu eine Anzahl (z. B 5) der ähnlichsten Fahrzeuge 4 aus der Flotte 3 gesucht und über die ermittelten nächsten Nachbarn eine Wahrscheinlichkeitsdichte gefittet. Durch Mittelwert- und Standard-Abweichungsbildung ist nun für MC1, MC2 und MC3 jeweils eine Prädiktion möglich. Grundsätzlich können auch hier nicht normalverteilte Wahrscheinlichkeitsdichten betrachtet werden, z. B. durch nicht-parametrische Verfahren.

Die so ausgewählten realen Alterungszustandsverläufe werden einer Auswertungsmenge von realen Alterungszustandsverläufen hinzugefügt, welche bereits in der Zentraleinheit 2 in einer Datenbank verfügbar sind. Auf diese Weise kann eine vorgegebene Anzahl von realen Alterungszustandsverläufen von in der Fahrzeugflotte existierenden Fahrzeugbatterien ausgewählt werden. Mit anderen Worten, die Nearest-Neighbor-Prädiktion ermöglicht es, dem Alterungszustandsverlauf der bestimmten Fahrzeugbatterie abhängig von den plausibilisierten Alterungszustandsverlaufskandidaten reale (zeitlich längere bzw. sich bis zum Ende der Lebensdauer erstreckende) Alterungszustandsverläufe aus der Datenbank der Zentraleinheit zuzuordnen, die dem Alterungszustandsverlauf der bestimmten Fahrzeugbatterie möglichst nahe kommen. Es ergibt sich somit zu jedem prädizierten Zeitschritt ein Histogramm von diversen möglichen und physikalisch plausiblen Prädiktionen des Alterungsverlaufs.

In Schritt S9 wird eine Wahrscheinlichkeitsdichtefunktion über die in der Auswertungsmenge enthaltenen realen Alterungszustandsverläufe berechnet, indem sämtliche in Schritt S8 berechneten Histogramme durch Addition in jedem prädizierten Zeitschritt kombiniert werden und ein erneuter Fit der Wahrscheinlichkeitsdichte-Funktion erfolgt. Grundsätzlich können auch hier nicht-normalverteilte Verteilungen z. B. durch nicht-parametrische Dichteschätzer abgebildet werden. In diesem Zuge wird auch die Wahrscheinlichkeitsdichte-Funktion für die zu erwartende Restlebensdauer des Energiespeichers berechnet. Es ergibt sich ein Verlauf eines Mittelwerts eines Alterungszustands mit einem entsprechenden Konfidenzintervall, das für die prädizierten Alterungszustände jeweils ein Maß der Prädiktionsunsicherheit als quantifizierte Unsicherheit angibt.

In Schritt S10 wird überprüft, ob ein Konvergenzkriterium erreicht ist. Vorteilhafterweise ist dieses Konvergenzkriterium mit dem Lebensdauer-Ende des zu prädizierenden Energiespeichers verknüpft. Das Konvergenzkriterium kann sich auf das Konfidenzintervall beziehen und ab der zweiten Iteration überprüfen, ob eine Änderung der Größe des Konfidenzintervall-Verlaufs geringer als ein vorgegebener Schwellenwert ist. Ist die Änderung der Größe des Konfidenzintervalls (vorzugsweise für mehrere Iterationen, z. B. 10 mal) geringer als der Schwellenwert (Alternative: Ja), so wird das Verfahren mit Schritt S11 beendet. In Schritt S11 wird ein Verlauf des Mittelwerts des Alterungszustands der zuletzt erhaltenen Wahrscheinlichkeitsdichtefunktion als prädizierter Verlauf des Alterungszustands für die bestimmte Fahrzeugbatterie bereitgestellt. Andernfalls (Alternative: Nein) wird das Verfahren mit Schritt S6 fortgesetzt.

Der so prädizierte Alterungszustandsverlauf wird nun als der dem bestimmten Energiespeicher des Kraftfahrzeugs zuzuordnende Alterungszustandsverlauf zugeordnet. In Folge kann der prädizierte Alterungszustandsverlauf verwendet werden, um eine Restlebensdauer mit statistischer Unsicherheitsquantifizierung zu ermitteln und diese in nachfolgenden Verfahren zum Ausgeben von Fahrempfehlungen zu nutzen oder anderweitig zu signalisieren. Insbesondere kann ein Austausch der Fahrzeugbatterie bei Erreichen einer Restnutzungsdauer von null signalisiert werden, wenn eine gewisse Wahrscheinlichkeit überschritten wird Diese Wahrscheinlichkeit wird durch Integration über die Wahrscheinlichkeitsdichtefunktion bzgl. der Restlebensdauer berechnet. Vorzugsweise werden hierbei eine Definition des Lebensdauer-Endes (z. B. SOH = 0.7) berücksichtigt. Z. B. kann hierzu das 50%-Quantil, also der Median, herangezogen werden, wann genau dieser Grenzwert laut Prädiktion überschritten wird.

## Patentansprüche

1. Computer-implementiertes Verfahren zum Bestimmen eines prädizierten Alterungszustands eines elektrischen Energiespeichers (41) in einer Maschine (4), insbesondere eines elektrisch antreibbaren Kraftfahrzeugs, mit folgenden Schritten:
- Bereitstellen (S1) eines datenbasierten oder hybriden Alterungszustandsmodells, wobei das datenbasierte Alterungszustandsmodell trainiert ist, um abhängig von Betriebsgrößen (F) eines Energiespeichers (41) und/oder aus Betriebsgrößen (F) abgeleiteten Betriebsmerkmalen (M) einen Alterungszustand anzugeben und eine Modellunsicherheit des angegebenen Alterungszustands anzugeben;
- Ermitteln (S4) eines Alterungszustandsverlaufs und der zugeordneten Modellunsicherheit eines bestimmten Energiespeichers (41) abhängig von dessen Betriebsgrößen (F) mithilfe des Alterungszustandsmodells;
- Generieren (S6) eines oder mehrerer zufälliger konstruierter Alterungszustandsverlaufskandidaten, die konstruierten Alterungszustandsverläufen innerhalb eines Verlaufs von Konfidenzintervallen entsprechen, wobei der Verlauf der Konfidenzintervalle durch die Modellunsicherheiten der Alterungszustände des ermittelten Alterungszustandsverlaufs bestimmt ist;
- aus einer Vielzahl von bereitgestellten Alterungszustandsverläufen von realen Energiespeichern (41) von weiteren Maschinen (4), Auswählen (S8) einer Anzahl von realen Alterungszustandsverläufen, die zu dem einen oder den mehreren Alterungszustandsverlaufskandidaten am nächstliegenden sind;
- Ermitteln (S9) einer Wahrscheinlichkeitsdichte über die ausgewählten realen Alterungszustandsverläufe, insbesondere durch Anfitten, um einen Verlauf des Mittelwerts des Alterungszustands als prädizierter Alterungszustandsverlauf zu bestimmen;
- Signalisieren (S11) des prädizierten Alterungszustandsverlaufs.

2. Verfahren nach Anspruch 1, wobei die Alterungszustandsverlaufskandidaten plausibilisiert werden, bevor diese für die Ermittlung der Wahrscheinlichkeitsdichtefunktion verwendet werden, wobei unplausible Alterungszustandsverlaufskandidaten nicht für die Ermittlung der Wahrscheinlichkeitsdichtefunktion berücksichtigt werden.

3. Verfahren nach Anspruch 1 oder 2, wobei die Schritte des Generierens des einen oder der mehreren Alterungszustandsverlaufskandidaten und des Auswählens von realen Alterungszustandsverläufen mehrfach durchgeführt werden, wobei die ausgewählten realen Alterungszustandsverläufe jeweils einer Auswertemenge hinzugefügt werden, wobei das Ermitteln der Wahrscheinlichkeitsdichtefunktion abhängig von den ausgewählten realen Alterungszustandsverläufen der Auswertemenge durchgeführt wird.

4. Verfahren nach Anspruch 3, wobei das mehrfache Ausführen der Schritte so lange durchgeführt wird, bis ein Konvergenzkriterium erfüllt ist, wobei das Konvergenzkriterium von einer gesamten Konfidenz abhängt, die sich aus dem Verlauf der Varianz oder der Standardabweichung der Wahrscheinlichkeitsdichtefunktion ergibt, wobei insbesondere das Konvergenzkriterium von einer Änderung der gesamten Konfidenz in aufeinanderfolgenden Durchläufen der Schritte des Generierens und des Auswählens abhängt.

5. Verfahren nach einem der Ansprüche 1 bis 4, wobei das Auswählen von realen Alterungszustandsverläufen, die zu dem einen oder den mehreren Alterungszustandsverlaufskandidaten am nächstliegenden sind, mithilfe eines Nearest Neighbour-Verfahrens, insbesondere unter Nutzung eines Least-Square-Verfahrens, in einem mehrdimensionalen Betriebsmerkmalsraum oder bezüglich des zeitlichen oder nutzungsabhängigen Verlaufs des jeweiligen Alterungszustandsverlaufskandidaten durchgeführt wird.

6. Verfahren nach einem der Ansprüche 1 bis 5, wobei der prädizierte Alterungszustandsverlauf an die batteriebetriebene Maschine (4) übermittelt wird und wobei diese abhängig von dem prädizierten Alterungszustandsverlauf betrieben wird.

7. Verfahren nach einem der Ansprüche 1 bis 6, wobei der prädizierte Alterungszustandsverlauf verwendet wird, um eine Restlebensdauer mit statistischer Unsicherheitsquantifizierung zu ermitteln und diese in nachfolgenden Verfahren zum Ausgeben von Betriebsempfehlungen zu nutzen oder zu signalisieren.

8. Verfahren nach einem der Ansprüche 1 bis 7, wobei der prädizierte Alterungszustandsverlauf verwendet wird, um einen Austausch des Energiespeichers (41) bei Erreichen einer Restlebensdauer von null zu signalisieren, wenn eine Prädiktions-Unsicherheit eine vorgegebene Unsicherheitsschwelle unterschreitet, wobei die Prädiktions-Unsicherheit durch Integration über die Wahrscheinlichkeitsdichtefunktion bezüglich der Restlebensdauer berechnet wird.

9. Verfahren nach einem der Ansprüche 1 bis 8, wobei das Ermitteln einer Wahrscheinlichkeitsdichte durch Aufaddieren von Histogrammen von zu jedem Auswertungszeitpunkt ermittelten Alterungszuständen der ausgewählten realen Alterungszustandsverläufen durchgeführt wird.

10. Verfahren nach einem der Ansprüche 1 bis 9, wobei der Energiespeicher (41) zum Betrieb einer Maschine (4), wie einem Kraftfahrzeug, einem Pedelec, einem Fluggerät, insbesondere einer Drohne, einer Werkzeugmaschine, einem Gerät der Unterhaltungselektronik, wie ein Mobiltelefon, einem autonomen Roboter und/oder einem Haushaltsgerät verwendet wird.

11. Vorrichtung zum Bestimmen eines prädizierten Alterungszustands eines elektrischen Energiespeichers (41) in einer batteriebetriebenen Maschine (4), insbesondere eines elektrisch antreibbaren Kraftfahrzeugs, insbesondere in einer maschinenexternen Zentraleinheit (2), wobei die Vorrichtung ausgebildet ist, zum:
- Bereitstellen eines datenbasierten oder hybriden Alterungszustandsmodells, wobei das datenbasierte Alterungszustandsmodell trainiert ist, um abhängig von Betriebsgrößen (F) eines Energiespeichers (41) und/oder aus Betriebsgrößen (F) abgeleiteten Betriebsmerkmalen (M) einen Alterungszustand anzugeben und eine Modellunsicherheit des angegebenen Alterungszustands anzugeben;
- Ermitteln eines Alterungszustandsverlaufs und der zugeordneten Modellunsicherheit eines bestimmten Energiespeichers (41) abhängig von dessen Betriebsgrößen (F) mithilfe des Alterungszustandsmodells;
- Generieren eines oder mehrerer zufälliger konstruierter Alterungszustandsverlaufskandidaten, die konstruierten Alterungszustandsverläufen innerhalb eines Verlaufs von Konfidenzintervallen entsprechen, wobei der Verlauf der Konfidenzintervalle durch die Modellunsicherheiten der Alterungszustände des ermittelten Alterungszustandsverlaufs bestimmt ist;
- Auswählen einer Anzahl von realen Alterungszustandsverläufen, die zu dem einen oder den mehreren Alterungszustandsverlaufskandidaten am nächstliegenden sind, aus einer Vielzahl von bereitgestellten Alterungszustandsverläufen von realen Energiespeichern (41) von Maschinen (4) einer Vielzahl von Maschinen (4);
- Ermitteln einer Wahrscheinlichkeitsdichte über die ausgewählten realen Alterungszustandsverläufe, insbesondere durch Anfitten, um einen Verlauf des Mittelwerts des Alterungszustands als prädizierter Alterungszustandsverlauf zu bestimmen;
- Signalisieren des prädizierten Alterungszustandsverlaufs.

12. Computerprogrammprodukt umfassend Befehle, die bei der Ausführung des Programms durch mindestens eine Datenverarbeitungseinrichtung diese veranlassen, die Schritte des Verfahrens nach einem der Ansprüche 1 bis 10 auszuführen.

13. Maschinenlesbares Speichermedium, umfassend Befehle, die bei der Ausführung durch mindestens eine Datenverarbeitungseinrichtung diese veranlassen, die Schritte des Verfahrens nach einem der Ansprüche 1 bis 10 auszuführen.
